Europäisches Patentamt

(19) European Patent Office

Office européen des brevets

(11) Numéro de publication: **0 080 765 B1**

(12) **FASCICULE DE BREVET EUROPEEN**

(45) Date de publication du fascicule du brevet:
26.02.86

(21) Numéro de dépôt: **82201480.9**

(22) Date de dépôt: **22.11.82**

(51) Int. Cl.⁴: **B 28 D 5/00**

(54) **Procédé et machine pour subdiviser une plaque de céramique.**

(30) Priorité: **25.11.81 FR 8122043**

(43) Date de publication de la demande:
**08.06.83 Bulletin 83/23**

(45) Mention de la délivrance du brevet:
**26.02.86 Bulletin 86/9**

(84) Etats contractants désignés:
**DE FR GB IT**

(56) Documents cités:
**DE - B - 1 193 172**
**FR - A - 1 481 711**
**FR - A - 1 595 496**
**US - A - 3 730 410**
**US - A - 3 786 973**
**US - A - 4 247 031**

(73) Titulaire: **R.T.C. LA RADIOTECHNIQUE-COMPELEC Société anonyme dite:, 51 rue Carnot BP 301, F-92156 Suresnes Cédex (FR)**

(84) Etats contractants désignés: **FR**

(73) Titulaire: **N.V. Philips' Gloeilampenfabrieken, Groenewoudseweg 1, NL-5621 BA Eindhoven (NL)**

(84) Etats contractants désignés: **DE GB IT**

(72) Inventeur: **Hamel, Christian, SPID 209 rue de l'Université, F-75007 Paris (FR)**

(74) Mandataire: **Pinchon, Pierre et al, Société Civile S.P.I.D. 209 rue de L'Université, F-75007 Paris (FR)**

## Description

L'invention concerne un procédé pour subdiviser en morceaux une plaque de céramique dans laquelle on a préalablement créé au moins une première ligne de fragilisation, selon lequel on place cette plaque entre une première matrice qui présente une surface cylindrique convexe en regard de la plaque, et une deuxième matrice qui présente une surface cylindrique concave en regard de la plaque, les génératrices de la première surface et celle de la seconde surface étant sensiblement parallèles entre elles et parallèles à la susdite ligne de fragilisation.

Elle concerne également une machine pour subdiviser en morceaux une plaque de céramique, comportant une matrice qui présente une surface cylindrique convexe, et une deuxième matrice qui présente une deuxième surface cylindrique concave dont les génératrices sont sensiblement parallèles à celles de la première surface, au moins une des matries étant mobile par rapport à l'autre.

On utilise dans l'industrie électronique des circuits dits hybrides qui sont attachés à une plaque de céramique. Pour diminuer les coûts, on fabrique une pluralité de circuits sur une même plaque que l'on doit subdiviser, à un moment choisi du processus de fabrication, pour obtenir individuellement chacun des circuits.

On peut, bien entendu, scier les plaques mais le procédé le plus utilisé consiste à créer une ligne de fragilisation à l'avance sur la cérmique et à exercer ensuite une contrainte mécanique qui entraîne la rupture le long de cette ligne.

Dans l'art antérieur, on a proposé des solutions plus ou moins artisanales, comme de déposer la plaque de céramique sur une embase élastique, puis de passer un rouleau sur cette plaque pour réaliser la rupture selon les lignes de fragilisation. Avec ce procédé, le dosage de l'effort est peu reproductible et varie selon l'élastîcité de l'ambase, d'où un déchet important par casse en dehors des lignes prévues. On a aussi proposé une sorte de pince permettant d'appliquer une force de torsion aux plaques, ce qui oblige à traiter les lignes de rupture une par une.

Ces procédés ne donnent donc das satisfaction. It est toutefois une technique qui peut nous enseigner des procédés de casse de plaques: c'est la technique des semiconducteurs dans laquelle on a à subdiviser des plaquettes de semiconducteurs. Cependant la matière employée et les dimensions sont différentes, et ces technique ne peuvent s'appliquer à la casse de céramique qu'en prévoyant des aménagements.

Dans cette technique, un procédé de casse nous est enseigné par le brevet US—A—4 247 031. Ce brevet décrit une machine qui comporte une matrice courbe contre laquelle on applique une plaquette semiconductrice maintenue sur un support souple, et une deuxième matrice courbe à laquelle on applique une force pour la rapprocher de la deuxième matrice. On a imaginé d'utiliser une machine semblable pour casser des plaques de céramique. Une telle machine fait partie de l'état de la technique quoiqu'aucun document montrant cet art antérieur ne puisse être fourni. Dans le cas des substrats de céramique, la dimension des morceaux à obtenir n'est par très petite devant celle de la plaque de départ, et la machine présente l'inconvénient que l'effort à appliquer à la deuxième matrice est difficile à doser si l'on veut éviter qu'après la subdivision désirée, chaque morceau ne continue à se casser en morceaux plus petits.

Le but de la présente invention est de fournir un procédé et une machine qui évitent cet inconvénient.

L'invention est basée sur l'idée d'appliquer à la plaque à subdiviser, non pas un effort déterminé, mais une déformation géométriquement prédéterminée. Ainsi, au moment où se produit la fracture désirée, la contrainte appliquée s'annule et il ne peut plus se produire de bris ultérieur non désiré.

Un procédé selon l'invention est ainsi notamment remarquable en ce qu'on rapproche des deux matrices de ce premier ensemble de matrices jusqu'à ce qu'on obtienne entre elles une distance prédéterminée, suffisamment faible pour que la plaque de céramique soit brisée mais suffisante pour que les morceaux obtenus soient eux mêmes protétés d'une rupture.

Comme indiqué ci-dessus, l'avantage de ce procédé est qu'il évite toute brisure non désirée du produit fabriqué.

Dans une forme d'exécution particulière où la plaque de céramique est amenée entre les matrices au moyen d'une bande adhésive mobile, et où on a prélaablement créé dans la plaque de céramique au moins une deuxième ligne de fragilisation formant un angle avec la première, le procédé est également remarquable en ce qu'on place sur le trajet de la bande adhésive un deuxième ensemble de deux matrices, les génératrices des surfaces cylindriques du deuxième ensemble étant sensiblement parallèles à la deuxième ligne de fragilisation.

Cette disposition évite d'avoir à tourner la plaque pour la faire passer une seconde fois entre les matrices, ce qui nécessite une mécanisation complexe.

Une machine selon l'invention, ses deux matrices ayant des sections circulaires de rayons différents, $R_e$ étant le rayon de la matrice concave, la plaque de céramique ayant une épaisseur e, et les morceaux désirés ayant une dimension l dans le sens perpendiculaire aux lignes de fragilisation utilisées, est remarquable en ce qu'une butée limite la course des matrices l'une vers l'autre, laissant entre les deux matrices un espace sensiblement égal à

$$e + \{R_e \times [1 - \cos(\text{arc sin} \frac{l}{2R_e})]\},$$

les centres de sections circulaires étant élors sensiblement confondus.

Une telle machine ne provoque pas de brisures non désirées du produit fabriqué.

Avantageusement, les matrices de cette machine sont toutes deux en matériau rigide.

Ceci permet une meilleure définition géométrique de la déformation appliquée à la plaque à subdiviser.

Dans une forme de réalisation particulière, la machine est remarquable en ce que les deux matrices ont des sections circulaires de rayons différents et en ce que, lorsque ces matrices sont en butée dans la position où elles sont les plus rapprochées l'une de l'autre, les centres des sections circulaires sont sensiblement confondus.

L'avantage de cette forme de réalisation est qu'elle fournit un moyen particulièrement bon marché d'obtenir les conditions géométriques désirées.

Lorsqu'une telle machine comprend une bande transporteuse adhésive, celle-ci est avantageusement divisée en plusieurs rubans parallèles correspondant chacun à un morceau de céramique après la subdivision de la plaque dans une direction parallèle à celle de la bande transporteuse.

Ceci permet de séparer plus facilement les morceaux après leur passage dans la machine.

La description qui va suivre, en regard des figures décrivant des exemples non limitatifs, fera bien comprendre comment l'invention peut être réalisée.

La figure 1 représente en perspective une plaque de céramique dans laquelle on a créé une ligne de fragilisation.

La figure 2 représente, de face et de profil, une machine selon l'invention dans une position de chargement.

La figure 3 représente la même machine dans la position où les matrices sont en butée.

La figure 4 représente schématiquement une forme de mise en oeuvre particulière du procédé.

La figure 5 est une figure géométrique permettant d'expliquer le calcul des rayons de courbure des matrices.

La figure 6 représente la machine de la figure 2 en perspective.

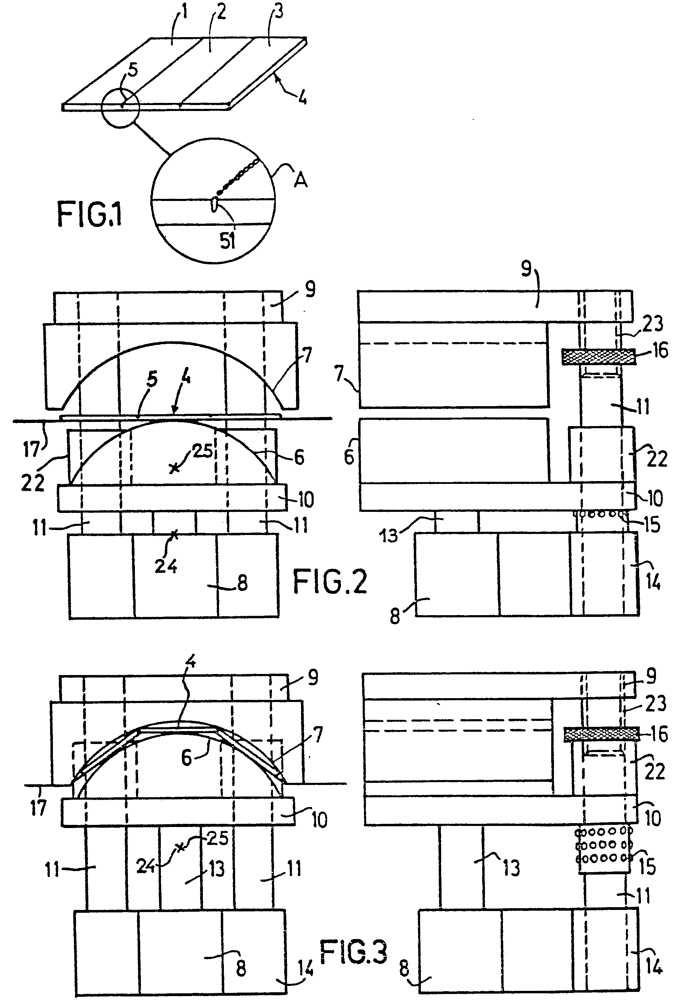

Sur la figure 1, est représentée une plaque de céramique 4 dans laquelle on a préalablement créé au moins une première ligne de fragilisation 5. Dans cet exemple, on désire créer trois morceaux 1, 2, 3 à partir de la plaque 4. La ligne de fragilisation 5 est engendrée, par exemple au moyen d'un pointillé de petits trous borgnes 51 creusés au moyen d'un laser, pointillé qui est représenté agrandi dans le cercle A.

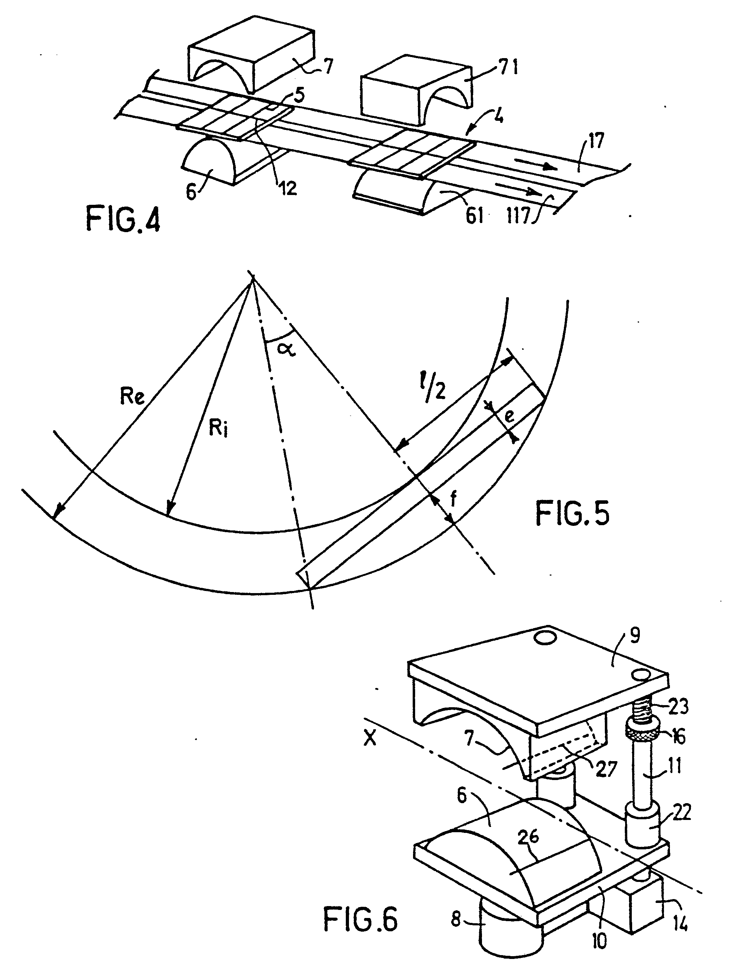

Pour casser la plaque 4, ainsi que le montre la figure 2, on place cette plaque contre une première matrice 6 qui présente une surface cylindrique convexe en regard de la plaque. De l'autre côté ce cette plaque 4, on place une deuxième matrice 7 qui présente une surface cylindrique concave en regard de la plaque, les génératrices de la première surface et celle de la seconde surface étant sensiblement parallèles. Pour illustrer cette disposition, une génératrice 26 de la surface 6 et une génératrice 27 de la surface 7 sont illustrées sur la figure 6 qui représente la même machine que la figure 2, et également en position de chargement, afin de mieux faire comprendre la figure 2. Les références des mêmes organes sont bien entendu les mêmes dans les deux figures. Ces génératrices 26, 27 parallèles entre elles sont également parallèles aux lignes de fragilisation 5: toutes ces lignes sont perpendiculaires au plan de la figure 2, dans la vue de face représentée à gauche.

Dans une forme de réalisation simple, ces deux matrices ont des sections circulaires de rayons différents. Les centres de ces sections circulaires sont représentés respectivement en 24 et 25 pour les matrices 6 et 7.

La machine représentée comporte un socle muni d'un vérin hydraulique 8 et de supports 14 pour des colonnes 11. Ces colonnes 11 supportent d'une part une plaque 9 sous laquelle est fixée la matrice 7, et d'autre part des manchons 22, coulissant sur des manchons à billes 15, et auxquels est fixée une plaque 10 qui supporte la matrice 6.

Cette plaque 10 peut être élevée ou abaissée au moyen du piston 13 du vérin 8, la matrice 6 étant donc mobile.

Après avoir placé la plaque 4 contre la matrice 6, on rapproche ensuite les deux matrices de ce premier ensemble de matrices jusqu'à ce que l'on obtienne entre elles une distance prédéterminée. Cette distance est obtenue en limitant la course des matrices l'une vers l'autre au moyen d'une butée, formée par exemple par une bague réglable 16, sur laquelle butent les manchons 22, ce qui stoppe la montée de la plaque 10 et de la matrice 6, la matrice 7 étant ici fixe.

La machine est représentée figure 3 avec ses matrices en butée dans la position où elles sont le plus rapprochées l'une de l'autre. Alors, les centres 24, 25 des sections circulaires des matrices sont sensiblement confondus. Bien entendu, il reste un espace entre les matrices dans lequel se trouve la plaque 4, ici cassée en trois morceaux ainsi qu'on le désire dans cet exemple. Dans la position représentée, la plaque séparée en trois morceaux ne subit plus aucune contrainte, chaque morceau étant logé exactement dans l'espace compris entre les matrices ainsi qu'il sera expliqué en détail plus loin à l'aide de la figure 5. L'espace en question étant défini avec précision, il n'est nul besion de prévoir une élasticité dans le dispositif et il à même été constaté que cela est nuisible. Les matrices sont donc avantageusement fabriquées toutes deux en un matériau rigide.

La bague de butée 16 est réglable grâce à un filetage 23 disposé sur la colonne 11, ce qui permet d'adjuster avec précision la hauteur de butée. Cette bague n'est pas représentée sur la vue de face afin de simplifier la figure. On peut se contenter d'une bague sur une des colonnes 11, ou bien en installer sur les deux colonnes, afin d'obtenir une meilleure définition de la position de la matrice 6.

Sur les figures 2, 3 et 4, on a également représenté une bande adhésive mobile 17 qui sert à amener les plaques 4 entre les matrices 6, 7, et à les emmener après leur casse. Cette bande est avantageusement collée sur la face opposée à celle qui porte les lignes 5, et placée du côté de la matrice convex alors que les lignes 5 sont du côté de la matrice concave.

Ainsi que cela est représenté sur la figure 4, il est habituel de créer préalablement dans la plaque de céramique 4 au moins une deuxième ligne de fragilisation 12, en plus de la première ligne 5, et formant un angle, en général un angle droit, avec elle.

Alors, il est avantageux de placer sur le trajet de la bande adhésive un deuxième ensemble de deux matrices 61, 71, les génératrices des surfaces cylindriques du deuxième ensemble 61, 71 étant sensiblement parallèles à la deuxième ligne de fragilisation 12. Dans l'art antérieur, il était courant de faire tourner la plaque 4 et de la presser une seconde fois contre la matrice convexe. Oture que ce procédé nécessite une mécanique compliquée, il est peu compatible avec le transport des plaques sur une bande adhésive. De plus, dans le cas de l'invention, la forme des matrices dépend de la dimension des morceaux que l'on désire obtenir, dimension qui est en général différente pour chaque direction des lignes 5 ou 12, et il est donc plus avantageux d'utiliser un deuxième ensemble de matrices, cette solution restant économique grâce au faible coût du dispositif selon l'invention.

La bande adhésive 17 est avantageusement divisée en plusieurs rubans parallèles 17, 117 correspondant chacun à un morceau de céramique après la subdivision de la plaque dans une direction parallèle à celle de la bande transporteuse. Dans l'exemple représenté par la figure 4, le premier ensemble de matrices 6, 7 casse la plaque selon les lignes 5 en créant ainsi trois morceaux qui sont collés chacun sur les deux bandes adhésives à la fois. Dans le deuxième ensemble de matrices 61, 71, la plaque est subdivisée dans la direction de la ligne 12, parallèle à celle de la bande transporteuse, et chaque ruban correspond à un des deux morceaux créés par la casse selon la ligne 12.

Pour simplifier la figure 4, on a représenté seulement les matrices proprement dites. Celles-ci sont supportées chacune par un dispositif du type décrit en référence aux figures 2, 3 et 6. Sur la figure 6, une ligne X rappelle la disposition du ruban transporteur, qui est la même par rapport aux colonnes 11, dans les deux ensembles 6, 7 et 61, 71, seule l'orientation des matrices étant changée. Un dispositif non représenté, connu de l'homme de métier, charge les plaques 4 sur le ruban 17, 117 en amont du dispositif représenté: en réglant ce dispositif pour qu'il dépose les plaques avec une écartement entre elles qui soit un sous-multiple entier de la distance qui sépare les deux ensembles de matrices 6, 7 et 61, 71, on peut alors actionner simultanément ces deux ensembles.

En ce qui concerne le choix du rayon de courbure des matrices, on a une certaine liberté, mais il y a par contre une relation précise entre les rayons des deux matrices d'un ensemble.

Pour la détermination du rayons de courbure de l'une des matrices, par exemple la matrice 7, on s'appuiera sur les considérations suivantes: une valeur minimale est imposée par la condition que la plaque 4 entière puisse entrer à l'intérieur de la matrice 7; ceci n'est possible qui se la diamètre de sa section est supérieur à la dimension de la plaque.

Quant à la valeur maximale, elle est fournie par la condition que le cintrage imposé à la plaque soit supérieur à celui permis par la limite élastique du matériau minu de ses lignes de fragilisation, faute de quoi la plaque aurait des chances de ne pas se casser. Cette valeur qui dépend des plaques et de la manière de réaliser les lignes de fragilisation peut être mesurée très facilement, de façon expérimentale.

Entre les valeurs minimale et maximale indiquées, il y a donc une plage de choix assez importante. Par contre, une fois une des rayons choisis, l'autre est calculé de la façon suivante en fonction de la dimension des morceaux que l'on désire obtenir: sur la figure 5, les sections des deux matrices sont représentées dans leur position la plus rapprochée par deux cercles de rayons $R_i$ et $R_e$. Le morceau à obtenir a une épasseur e et une largeur l; il est exactement inscrit entre les deux cercles. On peut tenir compte de la bande transporteuse en incorporant son épasseur dans la valeur choisie pour e. Soit l'angle a tel que:

$$\frac{l/2}{R_e} = \sin a$$

La flèche f est égale à:

$$f = R_e (1 - \cos a)$$

et

$$R_i = R_e - f - e = R_e \cos a - e$$

Une fois $R_e$ choisi, on calcule ainsi une valeur de $R_i$ bien déterminée, et la différence $R_e - R_i$ est ladite distance prédéterminée de l'écartement entre les matrices lorsqu' elles sont en butée dans la position où elles sont les plus rapprochées l'une de l'autre. On peut donc posséder un modèle unique de matrice 7 mais, en ce qui concerne la matrice 6, il faut un rayon de courbure $R_i$, spécifique pour chaque dimension de morceau désirée. Toutefois, on dispose d'une tolérance de plus et en moins: si, en position finale des matrices, les morceaux sont un peu contraints parce que l'écartement entre les matrices est trop faible, cela n'est pas gênant tant qu'on ne dépasse pas le cintrage cité ci-dessus correspondant à la limite élastique des morceaux (mais, ici, il s'agit de la limite élastique sans lignes de fragilisation). Si, par contre, en position finale les morceaux ont du jeu entre les matrices, cela n'a pas non plus d'importance à condition qu'on ait préalablement obtenu la rupture. On constante donc que l'on n'a pas besoin d'une matrice 6 par dimension, mais qu'avec une matrice on peut couvrir une gamme de dimensions: pour répondre à toutes les dimensions, on aura donc besoin seulement d'un nombre limité de matrices 6.

Il faut noter, toutefois, que dans le cas où les morceaux ont du jeu entre les matrices, celui-ci doit être très limité à cause d'un problème particulier: en général, la dimension des morceaux n'est pas un sous-multiple entier de la dimension de la plaque et il y a une chute, plus petite que les morceaux désirés. Si les morceaux ont du jeu, il se peut qu'un morceau arrive à être logé dans constrainte entre les matrices avec la chute accolée à lui, si celle-ci est petite, et la chute n'est alors pas séparée. Ceci nous amène à énoncer une condition supplémentaire concernant le choix du rayon $R_e$ maximal: il faut qu'un morceau accolé à la chute, placé entre les matrices rapprochées en butée, ait une cambrure suffisante pour dépasser la limite élastique. Pour une dimension de morceau donnée, c'est pour le rayon $R_e$ le plus petit que la cambrure due à l'excès de largeur du morceau accolé à la chute sera la plus grande. L'expérience est le moyen le plus simple pour obtenir une valeur de rayon maximal pour lequel la chute est séparée. On a constaté également qu'un chute inférieure à une certaine dimension ne pourra pas être séparée correctement, quelque soit le procédé utilisé. Un rayon $R_e$ de l'ordre de grandeur de la largeur, avant casse, des plaques 4, est une bonne valeur moyenne de départ que l'expérience permet d'affiner.

Il est bien évident que tout ce qui a été expliqué ci-dessus à propos des matrices 6 et 7 est parfaitement réversible: la matrice concave peut remplacer la matrice convexe, et réciproquement; n'importe laquelle des deux, ou les deux à la fois, peuvent être mobiles; la matrice dont on possède un modèle unique peut être la matrice convexe et les matrices concaves peuvent être adaptées aux dimensions des morceaux.

D'autres modes de réalisation que ceux indiqués ici peuvent, bien entendu, être mis en oeuvre: les matrices peuvent être supportées par des biellettes au lieu d'être coulissantes; le vérin hydraulique peut être remplacé par tout autre moyen de poussée, par exemple par un levier à main. Dans une version très mécanisée, les deux ensembles de matrices de la figure 4 peuvent être associés au laser qui prépare les lignes de fragilisation pour constituer un appareil de découpe complet et autonome.

## Revendications

1. Procédé pour subdiviser en morceaux une plaque de céramique dans laquelle on a préalablement créé au moins une première ligne de fragilisation, selon lequel on place cette plaque entre une première matrice qui présente une surface cylindrique convexe en regard de la plaque, et une deuxième matrice qui présente une surface cylindrique concave en regard de la plaque, les génératrices de la première surface et celle de la seconde surface étant sensiblement parallèles entre elles et parallèles à la susdite ligne de fragilisation, caractérisé en ce qu'un rapproche ensuite les deux matrices de ce premier ensemble de matrices jusqu'à ce qu'on obtienne entre elles une distance prédéterminée, suffisamment faible pour que la plaque de céramique soit brisée, mais suffisante pour que les morceaux obtenus soient exu mêmes protégés d'une rupture.

2. Procédé selon la revendication 1, dans lequel on a préalablement créé dans la plaque de céramique au moins une deuxième ligne de fragilisation formant un angle avec la première, caractérisé en ce que la plaque de céramique est amenée entre les matrices au moyen d'une bande adhésive mobile, et en ce qu'on place sur le trajet de la bande adhésive un deuxième ensemble de deux matrices, les génératrices des surfaces cylindriques du deuxième ensemble étant sensiblement parallèles à la deuxième ligne de fragilisation.

3. Machine pour subdiviser en morceaux une plaque de céramique, comportant une première matrice qui présente une première surface cylindrique convexe, et une deuxième matrice qui présente une deuxième surface cylindrique concave dont les génératrices sont sensiblement parallèles à celles de la première surface, au moins une des matrices étant mobile par rapport à l'autre, les deux matrices ayant des sections circulaires de rayons différents, $R_e$ étant le rayon de la matrice concave, la plaque de céramique ayant une épaisseur e, et les morceaux désirés ayant une dimension l dans le sens perpendiculaire aux lignes de fragilisation utilisées, caractérisé en ce qu'une butée limite la course des matrices l'une vers l'autre, laissant entre les deux matrices un espace sensiblement égal à

$$e + R_e \times [1 - \cos (\text{arc sin} \frac{l}{2R_e})],$$

les centres des sections circulaires étant alors sensiblement confondus.

4. Machine selon la revendication 3 munie d'une bande transporteuse pour amener la plaque de céramique entre les matrices, caractérisée en ce que ladite bande transporteuse est adhésive, et en ce que sur son trajet est placé un deuxième ensemble de deux matrices dont les génératrices forment un angle avec celles du premier ensemble.

5. Machine selon la revendication 4, caractérisée en ce que la bande adhésive est divisée en plusieurs rubans parallèles correspondant chacun à un morceau de céramique, après la subdivision de la plaque dans une direction parallèle à celle de la bande transporteuse.

**Patentansprüche**

1. Verfahren zum Zerteilen einer keramischen Platte in Stücke, in der wenigstens eine erste Brechlinie vorher angebracht ist, wobei die Platte zwischen eine erste Matrize, die eine zylinderförmige konvexe Oberfläche aufweist, welche der Platte zugewandt ist und eine zweite Matrize gelegt wird, die eine zylinderförmige konkave Oberfläche aufweist, welche der Platte zugewandt ist, wobei die Mantellinie der ersten Oberfläche und die der zweiten Oberfläche im wesentlichen zueinander parallel liegen und parallel zu der genannten Brechlinie, dadurch gekennzeichnet, dass die zwei Matrizen des ersten Matrizengefüges aufeinander zu bewegt werden, biz zwischen denselben ein vorbestimmter Abstand erhalten wird, der klein genug ist um die keramische Platte zu brechen, aber ausreicht um die erhaltenen Stücke selbst vor Bruch zu schützen.

2. Verfahrennach Anspruch 1, wobei wenigstens eine zweite Brechlinie, die einen Winkel mit der ersten Brechlinie bildet, vorher in der keramischen Platte angebracht ist, dadurch gekennzeichnet, dass die keramische Platte mittels eines beweglichen Klebestreifens zwischen die Matrizen gebracht wird und dass ein zweites Gefüge zweier Matrizen in die Bahn des Klebestreifens gebracht wird, wobei die Mantellinien der zylinderförmigen Oberflächen des zweiten Gefüges sich im wesentliche parallel zu der zweiten Brechlinie erstrecken.

3. Vorrichtung zum Zerteilen einer keramischen Platte in Stücke mit einer ersten Matrize, die eine erste zylinderförmige konvexe Oberfläche aufweist und mit einer zweiten Matrize, die eine zweite zylinderförmige konkave Oberfläche aufweist, deren Mantellinien sich im wesentlichen parallel zu denen der ersten Oberfläche erstrecken, wobei wenigstens eine der Matrizen gegenüber der anderen beweglich ist, wobei die zwei Matrizen kreisförmige Querschnitte mit unterschiedlichen Radien aufweisen, wobei $R_e$ der Radius der konkaven Matrize ist, wobei die keramische Platte eine Dicke $e$ hat und die erwünschten Stücke eine Grösse $l$ in Richtung senkrecht zu den verwendeten Brechlinien haben, dadurch gekennzeichnet, dass ein Anschlag den Hub der Matrizen gegenüber einander beschränkt, wobei zwischen den zwei Matrizen ein Raum im wesentlichen entsprechend

$$e + R_e[1 - \cos(\arc\sin\frac{1}{2R_e})]$$

übrig bleibt, wobei die Mittelpunkte der kreisförmigen Querschnitte dann im wesentlichen zusammenfallen.

4. Vorrichtungnach Anspruch 3 mit einem Transportstreifen um die keramische Platte zwischen die Matrizen zu bringen, dadurch gekennzeichnet, dass der genannte Transportstreifen ein Klebestreifen ist und dass in seiner Bahn ein zweites Gefüge zweier Matrizen angeordnet ist, deren Mantellinien einen Winkel mit denen des ersten Gefüges einschliessen.

5. Vorrichtungnach Anspruch 4, dadurch gekennzeichnet, das der Klebestreifen in mehrere parallelé Bänder aufgeteilt ist, die je einem Stück des keramischen Materials nach der Zerteilung der Platte in einer Richtung parallel zu der des Transportstreifens zugeordnet sind.

**Claims**

1. A method of subdividing into pieces a ceramic plate in which at least one first line of fracture has previously been formed, according to which method this plate is arranged between a first die which has a cylindrical convex surface facing the plate and a second die which has a cylindrical concave surface facing the plate, the generatrices of the first surface and of the second surface being substantially parallel to each other and parallel to the aforementioned line of fracture, characterized in that the two dies of this first assembly of dies are then moved towards each other until a predetermined distance between them is obtained which is sufficiently small for the ceramic plate to be broken, but is sufficient to protect the resulting pieces themselves from breaking.

2. A method as claimed in Claim 1, in which at least one second line of fracture enclosing an angle with the first line of fracture has previously been formed in the ceramic plate, characterized in that the ceramic plate is brought between the dies by means of a movable adhesivé tape, and in that a second assembly of two dies is arranged in the path of the adhesive tape, the generatrices of the cylindrical surfaces of the second assembly being substantially parallel to the second line of fracture.

3. A machine for subdividing into pieces a ceramic plate comprising a first die which has a cylindrical convex first surface and a second die which has a cylindrical concave second surface whose generatrices are substantially parallel to those of the first surface, at least one of the dies being movable with respect to.the other, the two dies having circular cross-sections of different radii, $R_e$ being the radius of the concave die, the ceramic plate having a thickness $e$ and the desired pieces having a dimension $l$ in the direction at right angles to the lines of fracture used, characterized in that a stop limits the stroke of the dies relative to each other while leaving between the two dies a space substantially equal to

$$e + R_e \times [1 - \cos(\arc\sin\frac{1}{2R_e})],$$

the centres of the circular crosssection then substantially coinciding.

4. A machine as claimed in Claim 3 provided with a transport tape for bringing the ceramic plate between the dies, characterized in that the said transport tape is adhesive and in that a second assembly of two dies is arranged in its path, whose generatrices enclose an angle with those of the first assembly.

5. A machine as claimed in Claim 4, characterized in that the adhesive tape is subdivided into several parallel tapes each corresponding to a piece of ceramic material after the subdivision of the plate in a direction parallel to that of the transport tape.

0 080 765

FIG.1

FIG.2

FIG.3

1

FIG.4

FIG.5

FIG.6